# EUROPÄISCHE PATENTSCHRIFT

(11) **EP 1 404 955 B1**
(45) Veröffentlichungstag und Bekanntmachung des Hinweises auf die Patenterteilung: **04.05.2005**
(21) Anmeldenummer: 02735221.0
(22) Anmeldetag: 04.04.2002
(51) Int. Cl.: F02B 77/02, F02B 77/04, F02B 23/00, F02F 3/14

(54) **VERBRENNUNGSKRAFTMASCHINE MIT KATALYTISCHER BESCHICHTUNG**
INTERNAL COMBUSTION ENGINE WITH CATALYTIC COATING
MOTEUR A COMBUSTION INTERNE AVEC REVETEMENT CATALYTIQUE

(30) Priorität: 28.06.2001 DE 10130673
(43) Veröffentlichungstag der Anmeldung: 07.04.2004
(73) Patentinhaber: Volkswagen Aktiengesellschaft, 38436 Wolfsburg (DE); O.M.T. GMBH, 23569 Lübeck (DE)
(72) Erfinder: SUCK, Gerrit, 31275 Lehrte (DE); SÖHLKE, Günter, 38518 Gifhorn (DE); REPENNING, Detlev, 21465 Reinbeck (DE)
(86) Internationale Anmeldenummer: PCT/EP2002/003741
(87) Internationale Veröffentlichungsnummer: WO 2003/002859

(56) Entgegenhaltungen:
- DE-A1- 4 317 254
- US-A- 2 782 592
- US-A- 4 529 626
- US-A- 4 530 340
- US-A- 5 891 584

## Beschreibung

Die Erfindung betrifft eine Verbrennungskraftmaschine mit den im Oberbegriff des Anspruchs 1 genannten Merkmalen.

Gattungsgemäße Verbrennungskraftmaschinen (Hub-Kolbenmotoren) mit äußerer oder innerer Gemischbildung sind hinreichend bekannt. Derartige Verbrennungskraftmaschinen weisen üblicherweise mehrere Zylinder auf, in denen ein axial beweglicher Kolben einen Brennraum, in welchem die Verbrennung eines zugeführten Luft-Kraftstoff-Gemisches erfolgt, einschließt.

Ein bekanntes Problem solcher Verbrennungskraftmaschinen stellen so genannte Verkokungsrückstände des zugeführten Kraftstoffes und Motoröls dar. Das sind bitumenartige und zum Teil sehr komplexe Kohlenwasserstoffgemische, die sich an Ventilen, Kolbenoberflächen, Einlasskanälen, Einspritzdüsen und am Brennraumdach abscheiden und ansammeln. Diese Verkokungsrückstände können sich insbesondere an Einlassventilen so weit akkumulieren, dass sie unerwünschte Veränderungen hinsichtlich Strömungsdynamik oder Schließverhalten des Ventils hervorrufen. Auch an anderen Bauteiloberflächen des Brennraums, beispielsweise einer Kolbenlauffläche, können sich Verkokungsrückstände äußerst nachteilig auswirken. Das Problem der Verkokung betrifft besonders Verbrennungskraftmaschinen, die über eine Kraftstoffdirekteinspritzung verfügen.

Aufgabe der vorliegenden Erfindung ist es, eine Verbrennungskraftmaschine zur Verfügung zu Stellen, die eine verminderte Bauteilverkokung aufweist.

Diese Aufgabe wird durch eine Verbrennungskraftmaschine mit den in dem unabhängigen Anspruch 1 genannten Merkmalen gelöst. Erfindungsgemäß weist eine mit einem im Brennraum zu verbrennenden Luft-Kraftstoff-Gemisch in Kontakt kommende Oberfläche mindestens eines Bauteils des Brennraums zumindest bereichsweise eine katalytische Beschichtung auf, die in der Lage ist, eine Oxidation von Verkokungsrückständen des dem Brennraum zugeführten Kraftstoffes und von Motoröl zu fördern. Die erfindungsgemäße Beschichtung vermag zwar nicht, die Verkokung und die Abscheidung der Verkokungsrückstände zu unterdrücken, jedoch bewirkt die schnelle Oxidation des kohlenstoffhaltigen Belages an einer Grenzfläche zwischen Katalysator und Belag bei typischen Betriebstemperaturen eine frühzeitige Ablösung der Ablagerung unter Wirkung der vorhandenen Strömung. Auf diese Weise kann ein Anwachsen der Verkokungsrückstände auf den betroffenen Oberflächen weitgehend reduziert werden oder sogar vollständig unterdrückt werden. Die Funktion der Bauteile beziehungsweise des Motors wird somit während der Lebensdauer nicht beeinträchtigt.

Erfindungsgemäß haben sich Beschichtungen aus ternäre Vanadiumoxidverbindungen, und mindestens eine weitere Verbindung mindestens eines Metalloxids umfasst, wobei das Metalloxid ein Ceroxid, ein Oxid eines anderen Seltenerd-Metalls, ein Oxid von Lanthan (La) und/oder ein Oxid eines Übergangsmetalls als vorteilaft erwiesen. Bauteile mit Vanadiumpentoxidbeschichtungen vermögen bereits bei Temperaturen ab zirka 300 °C, das heißt ab üblichen Betriebstemperaturen, eine schnelle oxidative Veraschung von Verkokungsrückständen zu bewirken. Ene Rückoxidation des bei diesem Prozess reduzierten Vanadiumpentoxids erfolgt dabei spontan, so dass seine katalytische Wirksamkeit erhalten bleibt. Hingegen zeigen unbeschichtete Bauteile selbst bei Temperaturen oberhalb von 400 °C keine Verbrennung der Ablagerungen, vielmehr neigen diese zu einem besonders nachteiligen Einbrennen in die üblicherweise aus Stahl oder Aluminium bestehenden Bauteile. Die ternäre Vanadiumoxidverbindungen sind insbesondere Vanadiumoxynitrid der Zusammensetzung V₂O_{5-X}N_{X} oder Vanadiumoxycarbid V₂O_{5-X}C_{X} mit 0 ≤ x ≤ 1.

Wie bereits erwähnt, kann besonders vorteilhaft vorgesehen sein, dass die als "Basiskatalysator" fungierende Beschichtung ternärem Vanadiumoxid weitere Zusätze enthält. Diesen Zusätzen kommt dabei die Aufgabe zu, der Ablagerung der Verkokungsrückstände noch stärker entgegenzuwirken beziehungsweise die katalytische Mindesttemperatur des Basiskatalysators in Richtung tieferer Temperaturen zu verschieben. Weiterhin können diese Zusätze ein Aufheizverhalten des aufspritzenden Öl-Rußgemisches verbessern und durch partielle Oxidation, Crackreaktionen und Shift-Reaktionen ein Verdampfen hochsiedender Kohlenwasserstoffanteile der Verkokungsrückstände beschleunigen. Als Zusätze kommen dabei die Metalloxide, in Frage. Als besonders vorteilhaft hat sich hier Ceroxid, insbesondere Cerdioxid CeO₂, erwiesen. Daneben kommen aber auch Oxide eines der anderen Seltenerd-Metalle und/oder von Lanthan in Frage. Weitere geeignete Verbindungen sind Übergangsmetalloxide, insbesondere der Eisengruppe (Fe, Co, Ni), der Platingruppe (Ru, Rh, Pd, Os, Ir, Pt), der Kupfergruppe (Cu, Ag, Au) und/oder der Zinkgruppe (Zn, Cd, Hg).

Die Aufbringung der Beschichtung auf die Oberfläche des betroffenen Bauteils erfolgt vorzugsweise mittels Plasma- und/oder Ionen-gestützter Vakuumverfahren, insbesondere durch Lichtbogenverdampfung eines geeigneten Targets in Gegenwart von Sauerstoff. Zur Erzeugung einer Vanadiumoxidschicht mit einem oder mehreren der genannten Zusätze kann hingegen ein Target verwendet werden, das aus einer Mischung/Legierung aus Vanadium und dem entsprechenden weiteren Metall besteht. Alternativ kann auch eine aufeinander folgende Lichtbogenverdampfung eines Vanadiumtargets und eines Targets des mindestens einen weiteren Metalls durchgeführt werden.

Ferner ist es möglich, reine Vanadiumoxidbeschichtungen zu erzeugen, indem eine geeignete Vanadiumverbindung, insbesondere Vanadiumnitrid oder Vanadiumcarbid, auf die zu beschichtende Oberfläche appliziert wird, um anschließend in Gegenwart von Sauerstoff bei Temperaturen von zirka 350 bis zirka 450 °C zu oxidieren.

Die Zumessung eines Metallzusatzes zu einer bereits erzeugten binären oder temären Vanadiumoxidschicht kann weiterhin durch "chemische Imprägnierung" erfolgen. Dabei wird eine Metallsalzlösung des zuzusetzenden Metalls, insbesondere als alkoholische Nitratlösung, auf die Basiskatalysatorschicht appliziert und anschließend in Gegenwart von Sauerstoff thermisch oxidiert.

Eine Variante zur Erzeugung der Vanadiumoxidbeschichtung ist die Aufbringung mittels SOL-GEL-Verfahren. Hierbei wird zunächst ein Gel erzeugt, wozu beispielsweise Vanadiumisopropoxid mit einen Ceralkoholat im gewünschten Mengenverhältnis gemischt wird und letztendlich mit Polyäthylenglycol versetzt wird. Das so erzeugte Gel wird auf die gewünschten Oberflächen aufgestrichen und in einem mehrstufigen Pyrolyseprozeß Temperaturen von ca. 400° C bis 500° C unterzogen, vorzugsweise 425° C bis 475° C, insbesondere 450° C. Durch diesen Pyrolyseprozeß entsteht ein nanostrukturierter Film aus Vanadiumdioxid (V₂O₅) und Cerdioxid (Ce0₂) mit hoher katalytischer Aktivität.

Weitere vorteilhafte Ausgestaltungen der Erfindung sind Gegenstand der übrigen Unteransprüche.

Die Erfindung wird nachfolgend in Ausführungsbeispielen anhand einer Zeichnung näher erläutert.

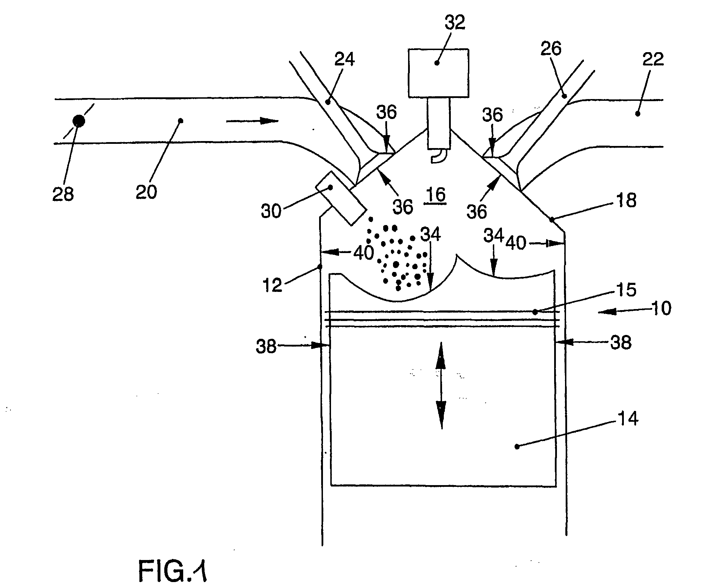

Die einzige Figur zeigt schematisch eine Schnittansicht brennraumrelevanter Komponenten einer Verbrennungskraftmaschine.

Von der insgesamt mit 10 bezeichneten Verbrennungskraftmaschine ist lediglich ein Zylinder 12 exemplarisch dargestellt. Selbstverständlich kann die Verbrennungskraftmaschine 10 über mehrere Zylinder 12 in unterschiedlichen Anordnungen verfügen. In dem Zylinder 12 ist axial beweglich ein Kolben 14 angeordnet, dessen Längsbewegung in eine Drehbewegung einer nicht dargestellten Kurbelwelle übertragen wird. Im Innenraum des Zylinders 12 wird ein Brennraum 16 durch den Kolben 14 begrenzt und Kolbenringe 15 abgedichtet. In einen Zylinderkopf 18 des Zylinders 12 mündet einerseits ein Einlasskanal 20, über den eine Luftzufuhr in den Brennraum 16 erfolgt, und andererseits ein Auslasskanal 22, welcher der Abführung von Abgas dient. Öffnung und Schließung von Einlasskanal 20 und Auslasskanal 22 erfolgen über ein Einlassventil 24 beziehungsweise ein Auslassventil 26, welche über eine nicht dargestellte Nockenwelle asynchron betrieben werden. Selbstverständlich können auch mehrere, jeweils mit entsprechenden Ventilen ausgestattete Ein- und Auslasskanäle vorgesehen sein, beispielsweise jeweils zwei. Ein dem Brennraum 16 zuzuführender Luftmassenstrom wird lastabhängig durch eine steuerbare, im Einlasskanal 20 angeordnete Drosselklappe 28 geregelt. Im Zylinderkopf 18 sind ferner ein Hochdruckeinspritzventil 30 zur Einspritzung von Kraftstoff in den Brennraum 16 sowie eine Zündkerze 32 zur Zündung des Luft-Kraftstoff-Gemisches angeordnet. Auch wenn vorliegend die Erfindung am Beispiel einer fremdgezündeten Verbrennungskraftmaschine erläutert wird, kann sie ebenso vorteilhaft für Dieselmotoren eingesetzt werden.

Wie bereits einleitend erläutert, unterliegen Verbrennungskraftmaschinen 10 mit Direkteinspritzung, insbesondere im mageren Schichtladebetrieb, dem Problem einer Verkokung des zugeführten Kraftstoffes und Motoröls resultierend in Ablagerungen von Verkokungsrückständen an den Oberflächen verschiedener Bauteile des Brennraums 16. Zunehmende Verkokungsablagerungen können dann zu einer Funktionsbeeinträchtigung der Verbrennungskraftmaschine 10 führen. Insbesondere können Verkokungsrückstände auf einer Ventiloberfläche 36 der Ein- und Auslassventile 24, 26 sowie an Innenwandungen der Ein- und Auslasskanäle 20, 22 nachteilige Veränderungen im Schließverhalten der Ventile 24, 26 und in der Strömungsdynamik der einströmenden Luft verursachen. Ablagerungen an dem üblicherweise präzisionsgeformten Kolbenboden 34 oder dem Brennraumdach des Zylinderkopfes 18 können ebenfalls zu einer ungünstigen Beeinflussung der im Brennraum 16 vorliegenden Strömungsverhältnisse führen und Verkokungsrückstände auf der Kolbenlauffläche 38 und der Zylinderlauffläche 40 können die Kolbenbewegung stören. Schließlich kann die Betriebsfunktion des Einspritzventils 30 durch Ablagerungen an der Einspritzdüse beeinträchtigt werden.

Erfindungsgemäß werden die vorstehend genannten gefährdeten Oberflächen zumindest teilweise mit einer katalytischen Beschichtung versehen, die eine schnelle Oxidation der anhaftenden Verkokungsrückstände und somit ihre Ablösung bei üblichen Betriebstemperaturen zu katalysieren vermag. Vorzugsweise enthält diese Beschichtung einen oxidationswirksamen Katalysator auf Basis von Vanadiumpentoxid, dessen Wirksamkeit durch Zusätze beispielsweise von Ceroxid, Wolframoxid und/oder Molybdänoxid weiter erhöht werden kann. Ferner können auch solche Stoffe zugesetzt werden, die eine schnellere Verdampfung der sich in der klebrigen bitumenartigen Masse ansammelnden hochsiedenden Kohlenwasserstoffe bewirken.

In einem ersten Ausführungsbeispiel wird mittels eines PVD-Vertahrens (physicalvapour-deposition), beispielsweise mit kathodischer Lichtbogenentladung, ein Target der Zusammensetzung 82% Vanadium und 18% Cer im Vakuum bei einem Sauerstoffdruck von 5x10⁻³ mbar eine Vanadium-Ceroxid-Mischphase an der Oberfläche 36 des Einlassventils 24 aufgetragen. Hierbei entsteht zunächst ein Suboxid der formelmäßigen Zusammensetzung (Ce_{y}V_{y})O_{2-X}, das durch anschließende spontane Nachoxidation an Luft schnell zu CeO₂/V₂O₅ oxidiert.

In einem weiteren Ausführungsbeispiel wird eine ähnliche Schicht hergestellt, indem zunächst unter gleichen Prozessbedingungen durch Verdampfen eines reinen Vanadiumtargets eine Vanadiumsuboxidschicht (Oxidationszahl < 5) auf der Oberfläche 36 des Einlassventils 24 abgeschieden wird. Anschließend wird aus einer alkoholischen Cemitratlösung ein dünner Film des Cernitrats auf die Vanadiumsuboxidschicht aufgesprüht. Durch Pyrolyse bei Temperaturen ≥ 400 °C bilden sich aus dem Vanadiumsuboxid und dem Cersalz die entsprechenden Mischoxide mit der jeweils höchsten Oxidationsstufe der beiden Metalle, das heißt +5 beziehungsweise +4.

Derartig beschichtete Ventile wurden in Simulationsversuchen in Laboröfen untersucht. Dabei erwies sich, dass ein Kohlenstoffölfilm sich bereits bei Temperaturen unterhalb 300 °C durch Grenzflächenoxidation wieder von der Ventiloberfläche zu lösen vermag. Spuren der Elemente Cer, Nickel, Chrom, Zink und/oder Molybdän in der Vanadiumpentoxidbeschichtung führen zu einer weiteren Verringerung der Bildung der voluminösen bitumenartigen Verkokungsrückstände. Dies lässt sich offensichtlich auf eine schnellere Verdampfung des Öls und einer hiermit einhergehenden, verringerten Agglomerisationsneigung von Rußpartikeln an der Oberfläche zurückführen.

Eine Variante zur Erzeugung der Vanadiumoxidbeschichtung ist die Aufbringung mittels SOL-GEL-Verfahren. Hierbei wird zunächst ein Gel erzeugt, wozu beispielsweise Vanadiumisopropoxid mit einen Ceralkoholat im gewünschten Mengenverhältnis gemischt wird und letztendlich mit Polyäthylenglycol versetzt wird. Das so erzeugte Gel wird auf die gewünschten Oberflächen aufgestrichen und in einem mehrstufigen Pyrolyseprozeß Temperaturen von ca. 400° C bis 500° C unterzogen, vorzugsweise 425° C bis 475° C, insbesondere 450° C. Durch diesen Pyrolyseprozeß entsteht ein nanostrukturierter Film aus Vanadiumdioxid (V₂O₅) und Cerdioxid (Ce0₂) mit hoher katalytischer Aktivität.

## Patentansprüche

1. Verbrennungskraftmaschine (10) mit mindestens einem durch einen Zylinder (12) und einen in diesem beweglich angeordneten Kolben (14) eingeschlossenen Brennraum (16), wobei eine mit einem zu verbrennenden Luft-Kraftstoff-Gemisch und/oder mit Motoröl in Kontakt kommende Oberfläche mindestens eines Bauteils des Brennraums (16) und/oder eines hieran angrenzenden Raumes zumindest bereichsweise eine katalytische Beschichtung zur Oxidation von Verkokungsrückständen aufweist, **dadurch gekennzeichnet, dass** die Beschichtung eine ternäre Vanadiumoxidverbindung und mindestens eine weitere Verbindung mindestens eines Metalloxids umfasst, wobei das Metalloxid ein Ceroxid, ein Oxid eines anderen Seltenerd-Metalls, ein Oxid von Lanthan (La) und/oder ein Oxid eines Übergangsmetalls ist.

2. Verbrennungskraftmaschine (10) nach Anspruch 1, **dadurch gekennzeichnet, dass** die ternäre Vanadiumoxidverbindung Vanadiumoxynitrid der Zusammensetzung V₂O_{5-X}N_{X} oder Vanadiumoxycarbid V₂O_{5-X}C_{X} mit 0 ≤ x ≤ 1 ist.

3. Verbrennungskraftmaschine (10) nach Anspruch 1 oder 2, **dadurch gekennzeichnet, dass** das Ceroxid Cerdioxid (CeO₂) ist.

4. Verbrennungskraftmaschine (10) nach einem der vorhergehenden Ansprüche, **dadurch gekennzeichnet, dass** das Übergangsmetall aus der Eisengruppe, der Platingruppe, der Kupfergruppe und/oder der Zinkgruppe ist.

5. Verbrennungskraftmaschine (10) nach einem der vorhergehenden Ansprüche, **dadurch gekennzeichnet, dass** das mindestens eine Bauteil ein Einlassventil (24), ein Auslassventil (26), ein Einlasskanal (20), ein Auslasskanal (22), ein Einspritzventil (30), der Kolben (14) und/oder der Zylinder (12) ist.

6. Verbrennungskraftmaschine (10) nach einem der vorhergehenden Ansprüche, **dadurch gekennzeichnet, dass** die Oberfläche eine Ventiloberfläche (36) von Einlassventil (24) und/oder Auslassventil (26), eine Innenwandung von Einlasskanal (20) und/oder Auslasskanal (22), eine Einspritzdüse des Einspritzventils (30), ein Kolbenboden (34) und/oder eine Kolbenlauffläche (38) des Kolbens (14) und/oder eine Zylinderlauffläche (40) und/oder ein Brennraumdach des Zylinders (12) ist.

7. Verbrennungskraftmaschine (10) nach einem der vorhergehenden Ansprüche, **dadurch gekennzeichnet, dass** die Verbrennungskraftmaschine (10) über eine Kwaftstoffdirekteinspritzung verfügt, mit welcher der Kraftstoff direkt in den Brennraum (16) einspritzbar ist.

8. Verbrennungskraftmaschine (10) nach einem der Ansprüche 1 bis 6, **dadurch gekennzeichnet, dass** die Beschichtung durch Plasma- und/oder Ionen-gestützte Vakuumverfahren auf die Oberfläche aufgebracht ist.

9. Verbrennungskraftmaschine (10) nach Anspruch 7, **dadurch gekennzeichnet, dass** die Beschichtung durch Lichtbogenverdampfung eines Targets aus Vanadium (V) oder eines Targets aus einer Legierung aus Vanadium (V) und des mindestens einen weiteren Metalloxids oder durch aufeinander folgende Lichtbogenverdampfung eines Targets aus Vanadium (V) und eines Targets des Metalls des mindestens einen weiteren Metalloxids in Gegenwart von Sauerstoff aufgebracht ist.

10. Verbrennungskraftmaschine (10) nach einem der Ansprüche 1 bis 6, **dadurch gekennzeichnet, dass** die Beschichtung durch Applikation einer Vanadiumverbindung, insbesondere Vanadiumnitrid oder Vanadiumcarbid, und anschließender thermischer Oxidation in Gegenwart von Sauerstoff auf die Oberfläche aufgebracht ist.

11. Verbrennungskraftmaschine (10) nach einem der Ansprüche 1 bis 6, **dadurch gekennzeichnet, dass** das mindestens eine Metailoxid durch Applikation einer Metallsalzlösung auf die Schicht aus der ternären Vanadiumoxidverbindung und anschließender thermischer Oxidation in Gegenwart von Sauerstoff in die Beschichtung eingebracht ist.

12. Verbrennungskraftmaschine (10) nach einem der Ansprüche 1 bis 6, **dadurch gekennzeichnet, dass** die Beschichtung durch Aufbringen eines Gels und einen anschließenden Pyrolyseprozess auf die Oberfläche aufgebracht ist.

13. Verbrennungskraftmaschine (10) nach Anspruch 11, **dadurch gekennzeichnet, dass** das Gel aus Vanadiumisopropoxid und einem Ceralkoholat besteht.

14. Verbrennungskraftmaschine (10) nach Anspruch 12, **dadurch gekennzeichnet, dass** das Gel mit Polyethylenglycol versetzt ist.

15. Verbrennungskraftmaschine (10) nach Anspruch 13, **dadurch gekennzeichnet, dass** das auf die gewünschten Oberflächen aufgetragene Gel einem Pyrolyseprozess bei einer Temperatur von etwa 400° C bis 500° C unterzogen wird.

## Claims

1. Internal combustion engine (10) having at least one combustion space (16) which is enclosed by a cylinder (12) and a piston (14) arranged movably therein, a surface of at least one component of the combustion space (16) and/or of an adjoining space which comes into contact with an air/fuel mix that is to be burnt and/or with engine oil having, at least in regions, a catalytic coating for the oxidation of coking residues, **characterized in that** the coating comprises a ternary vanadium oxide compound and at least one further compound of at least one metal oxide, the metal oxide being a cerium oxide, an oxide of another rare earth, an oxide of lanthanum (La) and/or an oxide of a transition metal.

2. Internal combustion engine (10) according to Claim 1, **characterized in that** the ternary vanadium oxide compound is vanadium oxynitride of composition V₂O₅₋ₓNₓ or vanadium oxycarbide V₂O₅₋ₓCₓ, where 0 ≤ x ≤ 1.

3. Internal combustion engine (10) according to Claim 1 or 2, **characterized in that** the cerium oxide is cerium dioxide (CeO₂).

4. Internal combustion engine (10) according to one of the preceding claims, **characterized in that** the transition metal is from the ion group, the platinum group, the copper group and/or the zinc group.

5. Internal combustion engine (10) according to one of the preceding claims, **characterized in that** the at least one component is an intake valve (24), an exhaust valve (26), an intake port (20), an exhaust port (22), an injection valve (30), the piston (14) and/or the cylinder (12).

6. Internal combustion engine (10) according to one of the preceding claims, **characterized in that** the surface is a valve surface (36) of intake valve (24) and/or exhaust valve (26), an inner wall of intake port (20) and/or exhaust port (22), an injection nozzle of the injection valve (30), a piston head (34) and/or a piston bearing surface (38) of the piston (14) and/or a cylinder bearing surface (40) and/or a combustion space roof of the cylinder (12).

7. Internal combustion engine (10) according to one of the preceding claims, **characterized in that** the internal combustion engine (10) has a direct fuel injection, by means of which the fuel can be injected directly into the combustion space (16).

8. Internal combustion engine (10) according to one of Claims 1 to 6, **characterized in that** the coating is applied to the surface by plasma- and/or ion-assisted vacuum processes.

9. Internal combustion engine (10) according to Claim 7, **characterized in that** the coating is applied by arc evaporation of a target made from vanadium (V) or of a target made from an alloy of vanadium (V) and the at least one further metal oxide or by successive arc evaporation of a target made from vanadium (V) and of a target made from the metal of the at least one further metal oxide in the presence of oxygen.

10. Internal combustion engine (10) according to one of Claims 1 to 6, **characterized in that** the coating is formed by application of a vanadium compound, in particular vanadium nitride or vanadium carbide, to the surface and subsequent thermal oxidation in the presence of oxygen.

11. Internal combustion engine (10) according to one of Claims 1 to 6, **characterized in that** the at least one metal oxide is introduced into the coating by application of a metal salt solution to the layer of the ternary vanadium oxide compound and subsequent thermal oxidation in the presence of oxygen.

12. Internal combustion engine (10) according to one of Claims 1 to 6, **characterized in that** the coating is applied to the surface by application of a gel and a subsequent pyrolysis process.

13. Internal combustion engine (10) according to Claim 11, **characterized in that** the gel consists of vanadium isopropoxide and a cerium alkoxide.

14. Internal combustion engine (10) according to Claim 12, **characterized in that** the gel is mixed with polyethylene glycol.

15. Internal combustion engine (10) according to Claim 13, **characterized in that** the gel which has been applied to the desired surfaces is subjected to a pyrolysis process at a temperature of approximately 400°C to 500°C.

## Revendications

1. Moteur à combustion interne (10) avec au moins une chambre de combustion (16) délimitée par un cylindre (12) et par un piston (14) mobile dans le cylindre, du type selon lequel une surface, venant en contact avec un mélange air-carburant à brûler et/ou avec de l'huile moteur, d'au moins un élément structural de la chambre de combustion (16) et/ou d'un espace contigu, présente au moins dans une zone un revêtement catalytique en vue de l'oxydation de résidus de cokéfaction, **caractérisé en ce que** le revêtement comprend un composé ternaire d'oxyde de vanadium et au moins un autre composé d'au moins un oxyde métallique, l'oxyde métallique étant un oxyde de cérium, un oxyde d'un autre métal de terre rare, un oxyde de lanthane (La) et/ou un oxyde d'un métal de transition.

2. Moteur à combustion interne (10) selon la revendication 1, **caractérisé en ce que** le composé ternaire d'oxyde de vanadium est l'oxynitrure de vanadium de composition V₂O₅₋ₓNₓ ou l'oxycarbure de vanadium V₂O₅₋ₓCₓ avec 0 ≤ x ≤ 1.

3. Moteur à combustion interne (10) selon la revendication 1 ou 2, **caractérisé en ce que** l'oxyde de cérium est le dioxyde de cérium (CeO₂).

4. Moteur à combustion interne (10) selon l'une des revendications précédentes, **caractérisé en ce que** le métal de transition est issu du groupe du fer, du groupe du platine, du groupe du cuivre et/ou du groupe du zinc.

5. Moteur à combustion interne (10) selon l'une des revendications précédentes, **caractérisé en ce que** le au moins un élément structural est une soupape d'admission (24), une soupape d'échappement (26), un canal d'admission (20), un canal d'échappement (22), une soupape d'injection (30), le piston (14) et/ou le cylindre (12).

6. Moteur à combustion interne (10) selon l'une des revendications précédentes, **caractérisé en ce que** la surface est une portée (36) de soupape d'admission (24) et/ou de soupape d'échappement (26), une paroi intérieure de canal d'admission (20) et/ou de canal d'échappement (22), un injecteur de la soupape d'injection (30), une tête de piston (34) et/ou une surface de glissement (38) du piston (14) et/ou une surface de glissement (40) du cylindre (12) et/ou une zone supérieure de la chambre de combustion du cylindre (12).

7. Moteur à combustion interne (10) selon l'une des revendications précédentes, **caractérisé en ce que** le moteur à combustion interne (10) dispose d'une injection directe de carburant, par laquelle le carburant est susceptible d'être injecté directement dans la chambre de combustion (16).

8. Moteur à combustion interne (10) selon l'une des revendications 1 à 6, **caractérisé en ce que** le revêtement est appliqué sur la surface par procédé plasma sous vide et/ou par procédé d'implantation ionique sous vide.

9. Moteur à combustion interne (10) selon la revendication 7, **caractérisé en ce que** le revêtement est appliqué en présence d'oxygène, par évaporation, par décharges d'arc électrique, d'une cible en vanadium (V) ou d'une cible en un alliage de vanadium (V) et de l'un au moins un autre oxyde métallique ou par la succession en superposition d'une évaporation, par décharges d'arc électrique, d'une cible en vanadium (V) et d'une cible du métal de l'un au moins un autre oxyde métallique.

10. Moteur à combustion interne (10) selon l'une des revendications 1 à 6, **caractérisé en ce que** le revêtement est appliqué sur la surface par application d'un composé de vanadium, en particulier de nitrure de vanadium ou de carbure de vanadium, et par oxydation thermique subséquente en présence d'oxygène.

11. Moteur à combustion interne (10) selon l'une des revendications 1 à 6, **caractérisé en ce que** l'au moins un oxyde métallique est introduit dans le revêtement par application d'une solution de sel métallique sur la couche à base du composé ternaire d'oxyde de vanadium et par oxydation thermique subséquente en présence d'oxygène.

12. Moteur à combustion interne (10) selon l'une des revendications 1 à 6, **caractérisé en ce que** le revêtement est appliqué sur la surface par application d'un gel et par un processus subséquent de pyrolyse.

13. Moteur à combustion interne (10) selon la revendication 11, **caractérisé en ce que** le gel se compose d'isopropoxyde de vanadium et d'un alcoolate de cérium.

14. Moteur à combustion interne (10) selon la revendication 12, **caractérisé en ce que** le gel est mélangé avec du polyéthylèneglycol.

15. Moteur à combustion interne (10) selon la revendication 13, **caractérisé en ce que** le gel déposé sur les surfaces souhaitées est soumis à un processus de pyrolyse à une température de l'ordre de 400 °C à 500 °C.
